# EUROPEAN PATENT APPLICATION

(11) **EP 2 075 838 A2**
(43) Date of publication of application: **01.07.2009**
(21) Application number: 08253850.5
(22) Date of filing: 01.12.2008
(51) Int. Cl.: H01L 25/075, H01L 33/00

(54) **Light source module with high heat dissipation efficiency**

(30) Priority: 28.12.2007 CN 200710203508
(71) Applicant: Foxsemicon Integrated Technology, Inc., Taiwan 350 (TW)
(72) Inventor: Tsao, Chih-Chung, Miao-Li Hsien, Taiwan 350 (TW); Jiang, Wen-Jang, Miao-Li Hsien, Taiwan 350 (TW)
(74) Representative: Stuttard, Garry Philip

(57) **Abstract**

The present invention in an exemplary embodiment relates to a light source module (20) which includes a thermoelectric cooler (200), many LED chips (300), and a circuit layer (400). The thermoelectric cooler (200) includes a first heat-conducting dielectric plate (210), a second heat-conducting dielectric plate (220) opposite to the first heat-conducting dielectric plate (210), and a number of thermoelectric elements (232) located between the first heat-conducting dielectric plate (210) and the second heat-conducting dielectric plate (220). The thermoelectric elements (232) are connected with each other. The LED chips (300) and the circuit layer (400) are formed on the first heat-conducting dielectric plate (210) and facing away from the second heat-conducting dielectric plate (220), and the LED chips (300) are electrically connected to the circuit layer (400).

## Description

The present invention relates to light source modules and particularly to a light source module with a high heat-dissipation efficiency.

A light emitting diode (LED) is one type of semiconductor light source, and the electrical and optical characteristics and life span thereof are greatly temperature-dependent. Generally, a high working temperature will cause a deterioration of an internal quantum efficiency of the LED and shorten the life span thereof. Furthermore, a resistance of a semiconductor has a negative temperature coefficient and tends to be reduced with an increase in the working temperature. Such a reduced resistance will correspondingly result in a larger current at a given voltage and the generation of excessive heat. If the excessive heat cannot be effectively dissipated, a phenomenon of heat accumulation will be difficult to avoid, and, accordingly, the deterioration of the LED may accelerate.

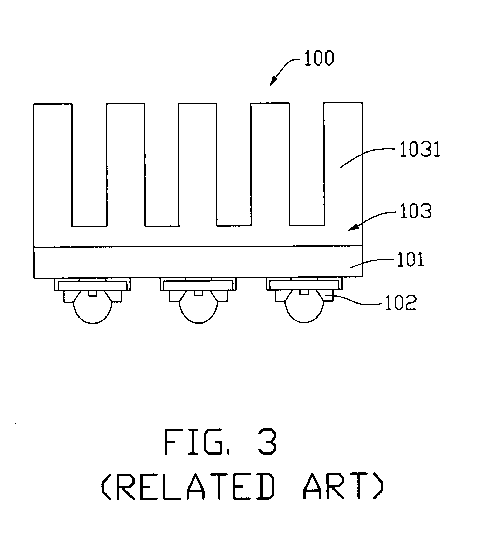

Referring to FIG. 3, a typical light source module 100 includes a printed circuit board 101, a plurality of LEDs 102 and a heat-dissipating member 103. The printed circuit board 101 defines two opposite surfaces (not labeled). The heat-dissipating member 103 and the LEDs 102 are respectively mounted on the two opposite surfaces of the printed circuit board 101. The heat-dissipating member 103 is thermally connected with the printed circuit board 101, with thermal grease or paste interposed therebetween to promote heat conduction. The heat-dissipating member 103 usually defines a plurality of heat dissipation fins 1031 on a surface thereof extending away from the printed circuit board 101. Such heat dissipation fins 1031 are configured (i.e., structured and arranged) for facilitating the dissipation of heat from the light source module 100. The LEDs 102 are electrically connected with the printed circuit board 101.

However, the LEDs 102 are spaced from the heat-dissipating member 103 via the printed circuit board 101, which has a relatively low thermal conductivity (i.e., acts more like a thermal insulator). Due to such presence of the printed circuit board 101, heat generated from the LEDs 102 during operation would not be immediately transmitted to the heat-dissipating member 103, thus not permitting effective heat dissipation. As such, the above-described phenomenon of heat accumulation will likely appear, and the deterioration of the light source module 100 would be accelerated.

Therefore, what is needed is to provide a light source module with high heat-dissipation efficiency.

An exemplary embodiment of a light source module includes a thermoelectric cooler, a plurality of LED chips, and a circuit layer. The thermoelectric cooler includes a first heat-conducting dielectric plate, a second heat-conducting dielectric plate opposite to the first heat-conducting dielectric plate, and a plurality of thermoelectric elements located between the first heat-conducting dielectric plate and the second heat-conducting dielectric plate. The thermoelectric elements are connected with each other. The LED chips and the circuit layer are formed on the first heat-conducting dielectric plate and facing away from the second heat-conducting dielectric plate, and the LED chips are electrically connected to the circuit layer.

Other advantages and novel features will become more apparent from the following detailed description of the present embodiments, when taken in conjunction with the accompanying drawings.

### BRIEF DESCRIPTION OF THE DRAWINGS

Many aspects of the present light source module can be better understood with reference to the following drawings. The components in the drawings are not necessarily drawn to scale, the emphasis instead being placed upon clearly illustrating the principles of the present light source module. Moreover, in the drawings, like reference numerals designate corresponding parts throughout the several views.

FIG. 1 is a schematic, cross-sectional view of a light source module, in accordance with an exemplary embodiment.

FIG. 2 is a schematic, cross-sectional view of the light source module with a light emitting diode having flip-chip chips.

FIG. 3 is a schematic, side view of a typical light source module.

The exemplifications set out herein illustrate at least one preferred embodiment, in one form, and such exemplifications are not to be construed as limiting the scope of the present light source module in any manner.

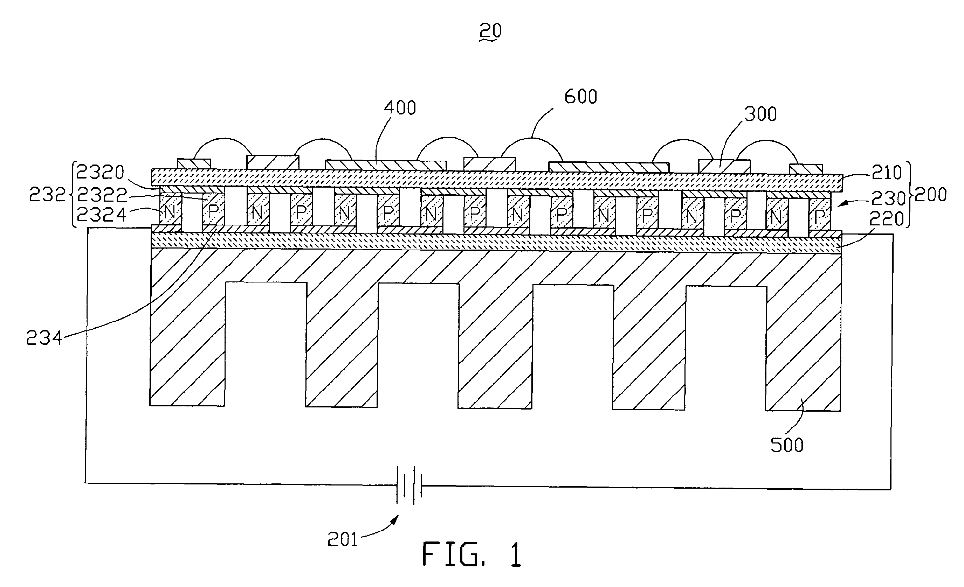

Referring to FIG. 1, a light source module 20, in accordance with an exemplary embodiment, is provided. The light source module 20 includes a thermoelectric cooler (hereinafter, TEC) 200, a plurality of LED chips 300, a circuit layer 400, and heat-dissipating fins 500.

The thermoelectric cooler 200 includes a first base board 210, a second base board 220 opposite to the first base board 210, and a thermoelectric cooling element group 230.

The first and second base boards 210, 220 are electrically insulating and have excellent thermal conductive performance. The first and second base boards 210, 220 can be made of ceramic, silicon, glass fiber, or anodic aluminum oxide (AAO) material.

The thermoelectric cooling element group 230 includes a plurality of thermoelectric elements 232 and a plurality of electric slice 234. The thermoelectric elements 232 are evenly distributed between the first base board 210 and the second base board 220 in an array. All of the thermoelectric elements 232 are electrically connected in series, and electrically connected to a direct current electrical source 201. That is, each two adjacent thermoelectric elements 232 are electrically connected with each other. In other embodiments, some thermoelectric elements 232 may be connected in series, and the remaining thermoelectric elements 232 may be connected in parallel. Each of the thermoelectric elements 232 includes a conductive substrate 2320, a P-type semiconductor 2322, and an N-type semiconductor 2324. The P-type and N-type semiconductors 2322, 2324 are both located at one side of the conductive substrate 2320 and electrically connected to the conductive substrate 2320. The conductive substrate 2320 is mounted to the first base board 210 facing towards the second base board 220. The P-type and N-type semiconductors 2322, 2324 are parallel to each other and located on the conductive substrate 2320 facing away the first base board 210. The electric slice 234 is mounted to the second base board 220 facing towards the first base board 210, and electrically connected with a P-type semiconductor 2322 of one thermoelectric element 232 and an N-type semiconductor 2324 of the adjacent thermoelectric element 232.

Each of the P-type semiconductors 2322 and the N-type semiconductors 2324 is a solid state block made of a compound semiconductor selected from the group consisting of Bi-Te based semiconductors, Sb-Te based semiconductors, Bi-Se based semiconductors, Pb-Te based semiconductors, Ag-Sb-Te based semiconductors, Si-Ge based semiconductors, Fe-Si based semiconductors, Mn-Si based semiconductors and Cr-Si based semiconductors. In the present embodiment, each of the P-type semiconductors 2322 and the N-type semiconductors 2324 is a Bi₂Te₃ based semiconductor.

The LED chips 300 are parallelly mounted on the first base board 210 directly. The circuit layer 400 is also formed on the first base board 210, and the LED chips 300 are electrically connected to the circuit layer 400 by metal wires 600.

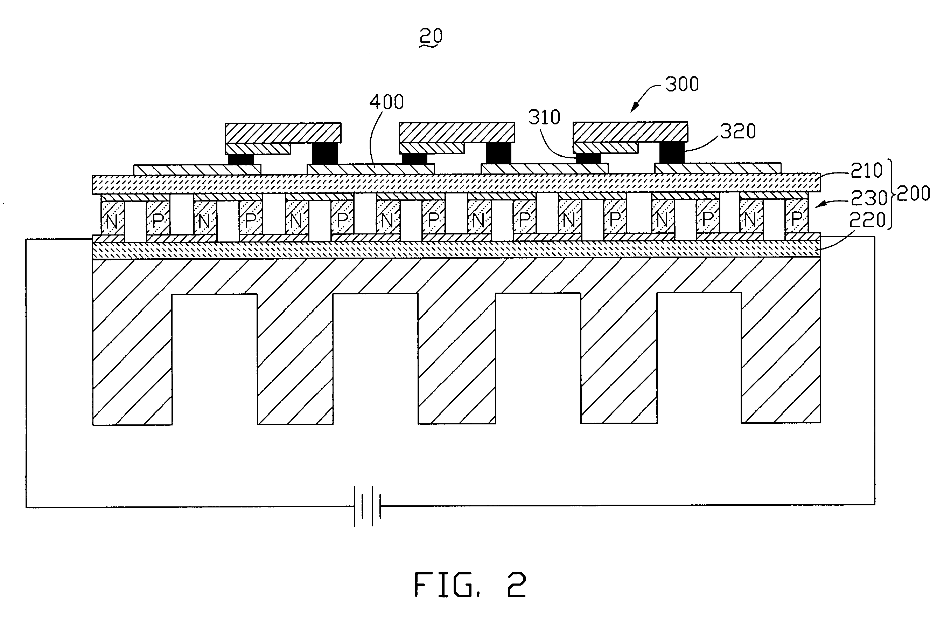

Referring to FIG. 2, the LED chips 300 are flip-chip bonded on the first base board 210 facing away from the second base board 220. That is, each LED chip 300 is equipped with a first electrical contact 310 and a second electrical contact 320 paired with the first electrical contact 310. The LED chips 300 are electrically connected with the circuit layer 400 via the respective paired first and second electrical contact 310, 320. The paired first and second electrical contact 310, 320 are soldered with the circuit layer 400.

The heat-dissipating fins 500 are usefully located on the second base board 220 and extending in a direction away from the first base board 210 and are used to facilitate direct conduction of heat therebetween.

The thermoelectric elements 232 may generate Peltier Effect therein, when the direct current electrical source 201 supplies power to the thermoelectric elements 232. Heat generated from the LED chips 300 can be effectively transferred from the end of the thermoelectric cooling element group 230 close to the first base board 210 to the other end of that close to the second base board 220 by the P-type and N-type semiconductors 2322, 2324. Because the first base board 210 has an increase thermal conductive performance, the P-type and N-type semiconductors 2322, 2324 have a higher performance. Thus, the heat generated from the LED chips 300 can be effectively transmitted to the second base board 220, and then quickly dissipated by the heat-dissipating fins 500.

The operating temperature of the thermoelectric cooler 200 can be controlled by regulating the voltage that the direct current electrical source 201 supplied, so the heat-dissipation efficiency of LED chips 300 can be accurately controlled by the thermoelectric cooler 200, such that the LED chips 300 can work at a constant temperature range, to ensure the LED chips 300 have stable photo-electric characteristics and improve work efficiency of the light source module 20. In addition, because the LED chips 300 are directly mounted on the first base board 210, heat generated from the LED chips 300 in operation can be immediately transmitted to the thermoelectric cooler 200 in a short distance, which could effectively improve the heat-dissipation efficiency of LED chips 300 by the thermoelectric cooler 200.

It is believed that the present embodiments and their advantages will be understood from the foregoing description, and it will be apparent that various changes may be made thereto without departing from the spirit and scope of the invention or sacrificing all of its material advantages, the examples hereinbefore described merely being preferred or exemplary embodiments of the present invention.

## Claims

1. A light source module comprising:
a thermoelectric cooler including a first heat-conducting dielectric plate, a second heat-conducting dielectric plate opposite to the first heat-conducting dielectric plate and a plurality of thermoelectric elements located between the first heat-conducting dielectric plate and the second heat-conducting dielectric plate, wherein the thermoelectric elements are connected to each other;
a plurality of LED chips; and
a circuit layer, wherein the circuit layer and the LED chips are formed on the first heat-conducting dielectric plate and face away from the second heat-conducting dielectric plate and the LED chips are electrically connected to the circuit layer.

2. A light source module as claimed in claim 1, wherein the LED chips are directly mounted on the first heat-conducting insulated plate.

3. A light source module as claimed in claim 1, wherein the LED chips are flip-chips bonded on the first heat-conducting dielectric plate.

4. A light source module as claimed in claim 1, wherein the LED chips are electrically connected to the circuit layer by metal wires.

5. A light source module as claimed in any preceding claim further comprising a plurality of heat-dissipating fins located on the second heat-conducting dielectric plate and extending in a direction away from the first heat-conducting dielectric plate.

6. A light source module as claimed in any preceding claim wherein the first and second heat-conducting dielectric plates are made of ceramic, silicon or anodic aluminum oxide material.

7. A light source module as claimed in any preceding claim wherein the thermoelectric elements each includes a conductive substrate, a P-type semiconductor and an N-type semiconductor, wherein the P-type and N-type semiconductors are parallel to each other and electrically connected to the conductive substrate, wherein each two adjacent thermoelectric elements are electrically connected with each other.

8. A light source module comprising:
a thermoelectric cooler including
a first heat-conducting dielectric plate at a cold side thereof,
a second heat-conducting dielectric plate at a hot side opposite to the first heat-conducting dielectric plate and
a plurality of thermoelectric elements located between the first heat-conducting dielectric plate and the second heat-conducting dielectric plate;
a plurality of LED chips formed on and brought into contact with the first heat-conducting dielectric plate; and
a circuit layer formed on and brought into contact with the first heat-conducting dielectric plate, wherein the LED chips are electrically connected to the circuit layer.

9. A light source module as claimed in claim 8, wherein the first heat-conducting dielectric plate comprises a material selected from the group consisting of ceramic, silicon, anodic aluminum oxide and glass fiber.
